# EUROPÄISCHE PATENTANMELDUNG

(11) **EP 2 141 018 A2**
(43) Veröffentlichungstag der Anmeldung: **06.01.2010**
(21) Anmeldenummer: 09008115.9
(22) Anmeldetag: 20.06.2009
(51) Int. Cl.: B32B 37/10, B32B 37/12, B32B 37/18

(54) **Verfahren und Vorrichtung zum Laminieren von im Wesentlichen plattenförmigen Werkstücken unter Druck- und Wärmeeinwirkung**

(30) Priorität: 02.07.2008 DE 102008030927
(71) Anmelder: Robert Bürkle GmbH, 72250 Freudenstadt (DE)
(72) Erfinder: Damm, Norbert, 76689 Karlsdorf-Neuthard (DE); Metzger, Dagmar, 76187 Karlsruhe (DE)
(74) Vertreter: Lemcke, Brommer & Partner

(57) **Zusammenfassung**

Die Erfindung betrifft ein Verfahren sowie eine Vorrichtung zum Laminieren von im Wesentlichen plattenförmigen Werkstücken mit mindestens einer durch Wärme aktivierbaren Kleberschicht unter Druck- und Wärmeeinwirkung. Es wird zunächst mindestens ein Werkstück (7) in eine Vakuumkammer (8) einer Vakuum-Laminierpresse eingefördert, die von einem gasdichten flexiblen Andrückmittel (6) in eine Produkthälfte (10) und eine Druckhälfte (9) unterteilt ist. Das Werkstück (7) wird in der Produkthälfte der Vakuumkammer unter Wärmeeinwirkung einem Laminierprozess unterzogen, bei dem die Produkthälfte (10) evakuiert wird und das Andrückmittel (6) durch den hierdurch entstehenden Differenzdruck und/oder durch ein zusätzliches Druckbeaufschlagen der Druckhälfte (9) der Vakuumkammer das Werkstück (7) direkt oder indirekt gegen die Unterseite der Vakuumkammer presst. Der Laminierprozess wird durch das Öffnen der Vakuum-Laminierpresse unterbrochen, das Werkstück (7) wird in einen Laminator überführt und dort mit einer Temperatur an oder oberhalb der Aktivierungstemperatur und/oder der Aushärtetemperatur der Kleberschicht beaufschlagt. Die Erfindung zeichnet sich dadurch aus, dass als flexibles Andrückmittel (6) eine separat oder mit dem Werkstück in die Vakuum-Laminierpresse eingeförderte Folie, oder aber eine durch die Vakuumkammer geführte Folienbahn verwendet wird.

## Beschreibung

Die Erfindung betrifft ein Verfahren zum Laminieren von im Wesentlichen plattenförmigen Werkstücken unter Druck- und Wärmeeinwirkung nach dem Oberbegriff des Anspruchs 1 sowie eine solche Vorrichtung nach dem Oberbegriff des Anspruchs 10. Die hierbei zu laminierenden Werkstücke sind mehrschichtig aufgebaut und enthalten mindestens eine Kleberschicht mit einem Kleber, der durch Wärmeeinwirkung aktiviert wird und gegebenenfalls auch unter Wärmeeinwirkung aushärtet. Das bevorzugte Anwendungsgebiet der vorliegenden Erfindung ist das Laminieren von Photovoltaik-Modulen, bei denen eine Solarzellenschicht mitsamt ihren elektrischen Kontaktierungselementen feuchtigkeitsdicht eingekapselt sowie wetterfest und dennoch lichtdurchlässig abgedeckt ist.

Im Rahmen der vorliegenden Erfindung wird eine Vakuum-Laminierpresse eingesetzt. Diese enthält eine Vakuumkammer, die beim Schließen der Presse luftdicht verschlossen wird, und die durch ein gasdichtes flexibles Andrückmittel in eine Produkthälfte und eine Druckhälfte unterteilt ist. Die Produkthälfte der Vakuumkammer ist zur Aufnahme von mindestens einem Werkstück vorgesehen und kann evakuiert werden. Die Druckhälfte der Vakuumkammer kann ebenfalls evakuiert werden, sowie gegebenenfalls durch Einleiten von Druckluft oder sonstigen Gasen mit Druck beaufschlagt werden. Das flexible Andrückmittel ist so ausgestaltet und angeordnet, dass es aufgrund eines durch Evakuieren der Produkthälfte und/oder durch ein gegebenenfalls zusätzliches Druckbeaufschlagen der Druckhälfte erzeugten Druckunterschieds in der Vakuumkammer das Werkstück direkt oder indirekt gegen eine Unterseite der Vakuumkammer presst. Diese Unterseite ist üblicherweise eine Heizplatte, die die notwendige Prozesswärme auf das Werkstück überträgt.

Eine solche Vakuum-Laminierpresse ist beispielsweise aus der WO 2006/128699 A2 bekannt. Dort ist über einer Heizplatte ein Oberteil mit einem Dichtrahmen angeordnet, der eine Vakuumkammer umschreibt. Beim Schließen der Presse wird der Dichtrahmen auf die Heizplatte dicht aufgelegt, so dass die Vakuumkammer evakuiert werden kann. Über den Dichtrahmen ist eine flexible Membran gespannt, welche die Vakuumkammer abschließt und als flexibles Andrückmittel dient, um den für die Laminierung des Werkstücks erforderlichen Druck gegen die Heizplatte aufzubringen. Hierfür wird das bei geschlossener Presse unter der Membran, zwischen dieser und der Heizplatte liegende Volumen, das die Produkthälfte der Vakuumkammer bildet, evakuiert, so dass sich die Membran eng an das Werkstück anlegt. Bedarfsweise wird außerdem eine durch Abdichten des Dichtrahmens gegen die obere Pressenplatte gebildete, nach unten von der Membran begrenzte Druckhälfte der Vakuumkammer mit Druckluft beaufschlagt.

Bei der Laminierung von Photovoltaik-Modulen ist es bislang unerlässlich, mit einer solchen Membran zu arbeiten, da diese Module meist eine unebene Oberfläche aufweisen und gleichwohl ein gleichmäßiger Druck darauf notwendig ist, um sicherzustellen, dass das Laminieren blasenfrei erfolgt. Denn durch Blasenbildung beim Laminieren würden Undichtigkeiten entstehen, durch die Feuchtigkeit in die Photovoltaik-Module eindringen kann.

Da zur Laminierung von Photovoltaik-Modulen in der Regel sehr stark adhäsive Klebstoffe verwendet werden, wird in der WO 2006/128699 A2 außerdem eine Trennfolie eingesetzt, die zwischen dem Werkstück und der Membran angeordnet wird und die Membran vor etwa aus dem Werkstück dringenden Klebstoffresten schützt. Denn Klebstoffreste an der Membran können diese unbrauchbar machen oder zumindest das Arbeitsergebnis bei folgenden Laminierprozessen verschlechtern; gleichzeitig können solche Klebstoffreste kaum mit vertretbarem Aufwand von der im Inneren der Vakuumkammer angebrachten Membran entfernt werden.

Die Ausbeute an elektrischer Energie von Photovoltaik-Modulen hängt direkt von deren Fläche ab. Dementsprechend beeinflusst die Verarbeitungskapazität pro Flächeneinheit bei zeitlich festgelegten Prozessen wie dem des Laminierens unmittelbar die Kosteneffizienz bei der Herstellung der Module.

Ein Weg, die Verarbeitungskapazität pro Flächeneinheit zu erhöhen, besteht darin, dass mehretagige Vakuum-Laminierpressen eingesetzt werden. Hierdurch erhöht sich allerdings der ohnehin schon hohe Energiebedarf beim Aufheiz- und Abkühlzyklus aufgrund der verringerten Wechselwirkung der einzelnen Heizplatten mit der Umgebung.

Beim vorliegenden Verfahren und der vorliegenden Vorrichtung wird ein anderer Weg zur Erhöhung der Verarbeitungskapazität beschritten: Die Verkürzung der Arbeitstakte. Hierzu wird der Laminierprozess in der Vakuum-Laminierpresse durch Öffnen derselben unterbrochen, sobald die Kleberschichten soweit aktiviert worden sind, dass das Herausziehen von gasförmigen Bestandteilen im Vakuum der Produkthälfte der Vakuumkammer abgeschlossen oder durch die Aktivierung der Kleberschicht zum Stillstand gekommen ist, und umgekehrt ein Eindringen von Luft von Außen in das Werkstück bzw. zwischen dessen Schichten ausgeschlossen ist. Zu diesem Zeitpunkt des Laminierprozesses wird das Werkstück dann aus der geöffneten Vakuum-Laminierpresse herausgenommen, da ein Weiterprozessieren, also in der Regel ein Aushärten der Kleberschicht, nicht mehr weiter unter Vakuum erfolgen muss. Dies übernimmt vielmehr ein Laminator, der die Werkstücke mit einer Temperatur an oder oberhalb einer Endtemperatur, die gegebenenfalls die Aushärtetemperatur der Kleberschicht ist, beaufschlagt, ohne Vakuumkammern zu enthalten. Die Vakuum-Laminierpresse ist also sehr viel schneller für einen weiteren Arbeitstakt bereit, als wenn das Aushärten der Kleberschicht in der Vakuum-Laminierpresse vollständig durchgeführt wird. Ein Beispiel für ein solches Verfahren ist in der WO 94/29106 A1 offenbart.

Ausgehend von diesem Stand der Technik liegt der vorliegenden Erfindung die Aufgabe zugrunde, ein Verfahren und eine Vorrichtung der eingangs genannten Art hinsichtlich der Investitions- und Betriebskosten sowie hinsichtlich des Wartungsaufwandes zu verbessern.

Gelöst ist diese Aufgabe durch ein Verfahren mit den Merkmalen des Anspruchs 1 sowie durch eine Vorrichtung mit den Merkmalen des Anspruchs 10.

Bevorzugte Weiterbildungen des erfindungsgemäßen Verfahrens finden sich in den Ansprüche 2 bis 9; bevorzugte Ausgestaltungen der erfindungsgemäßen Vorrichtung sind in den Ansprüchen 11 bis 18 niedergelegt.

Die vorliegende Erfindung zeichnet sich also dadurch aus, dass bei einem Verfahren und einer Vorrichtung der vorliegenden Art als flexibles Andrückmittel eine Folie verwendet wird, die nicht ortsfest in der Vakuum-Laminierpresse befestigt ist, sondern separat in die Vakuumkammer eingebracht oder zusammen mit dem Werkstück eingefördert wird. Die Folie kann auch als Folienbahn vorliegen, die durch die Vakuumkammer geführt wird, so dass der jeweils in der Vakuumkammer als Andrückmittel fungierende Abschnitt der Folienbahn, von außerhalb der Vakuumkammer angetrieben, in diese eingebracht und aus dieser herausgefördert werden kann. Die in einer Laminierpresse der vorliegenden Art bisher als Andrückmittel für unverzichtbar gehaltene fest angeordnete und zugelastische Membran wird demgemäß weggelassen.

Das flexible Andrückmittel ist also nicht mehr wie bisher fest im Inneren der Vakuum-Laminierpresse angeordnet, sondern wird, wie das Werkstück, in die Presse eingefördert und auch wieder aus dieser ausgefördert. Hierdurch verringert sich nicht nur der Wartungsaufwand ganz beträchtlich, weil das Austauschen von abgenutzten oder beschädigten Membranen vollständig entfällt, sondern auch die Herstellung einer erfindungsgemäß ausgestatteten Vakuum-Laminierpresse wird kostengünstiger. Gleichzeitig erhöht sich die Betriebssicherheit der Vakuum-Laminierpresse, da aus dem Werkstück etwa austretender Klebstoff zwar weiterhin an das flexible Andrückmittel gelangen kann, jedoch sich dadurch keine Probleme ergeben, weil das derart mit Klebstoffresten verunreinigte flexible Andrückmittel erfindungsgemäß aus der Vakuum-Laminierpresse herausgefördert werden kann und so das Arbeitsergebnis von nachfolgenden Laminierprozessen nicht beeinträchtigt. Wartungs- und störungsbedingte Stillstandszeiten aufgrund eines Membranwechsels gehören somit der Vergangenheit an. Dies ist deswegen besonders vorteilhaft, da die Stillstandszeiten bei einem Membranwechsel nicht vernachlässigbar sind: Um die Membran einer herkömmlichen Vakuum-Laminierpresse zu wechseln, muss die Presse zunächst abgekühlt und nach dem Abmontieren der alten sowie dem Anmontieren der neuen Membran wieder aufgeheizt werden.

Zum Schutz der Membran in einer herkömmlichen Vakuum-Laminierpresse gegen einen direkten Kontakt mit etwa aus dem Werkstück austretenden Klebstoffen ist es schon bisher üblich, eine Trennfolie zwischen das Werkstück und die Membran zu legen, die typischerweise in Bahnform vorliegt und aus einem Material besteht, das sich leicht vom Werkstück lösen lässt. Am effizientesten ist hierbei die Verwendung einer quasi endlos mit dem Werkstück oder gegebenenfalls auch unabhängig von diesem in die Vakuum-Laminierpresse eingeförderten Folienbahn, die zur Realisierung der vorliegenden Erfindung dann nur noch dahingehend modifiziert werden muss, dass sie die Aufgaben der bisher üblichen flexiblen Membran übernehmen kann, also die Produkt- und Druckhälften der Vakuumkammer gasdicht unterteilt sowie den in der Vakuumkammer der Vakuum-Laminierpresse herrschenden Druckunterschieden und den mechanischen Beanspruchungen am Werkstück standhält. Da ein solches Material relativ hochwertig ist, kann eine solche Folienbahn gegebenenfalls nicht quasi endlos, sondern tatsächlich endlos, also geschlossen um das Oberteil der Vakuum-Laminierpresse umlaufend vorgesehen sein, wobei dann vorzugsweise eine Reinigungsvorrichtung für das Beseitigen von etwaigen Klebstoffresten sorgt.

An das Material der erfindungsgemäßen Folie, die als flexibles Andrückmittel verwendet wird, werden im Übrigen keine so hohen Anforderungen gestellt, wie an die bisher in Vakuum-Laminierpressen verwendeten, nicht nur flexiblen, sondern auch zugelastischen Membrane. Diese hochelastischen Membrane legen sich (was sie beispielsweise bei der Möbelplattenherstellung ausdrücklich sollen) sehr eng und weitgehend auch an den Rändern der Werkstücke an diese an. Dies ist vorliegend allerdings nicht notwendig und sogar eher nachteilig, da sich hierdurch in den Randbereichen der Werkstücke erhöhte Druckbelastungen ergeben, was gerade bei Photovoltaik-Modulen zu Glasbruch oder zu einem Bruch der randseitig angeordneten Solarzellen führen kann. Ein weniger bzw. gar nicht elastisches und somit kostengünstigeres Folienmaterial hilft, solche Druckbelastungen zu vermeiden.

Bevorzugterweise werden mehrere Werkstücke, oder, soweit mehr als ein Werkstück in der Vakuum-Laminierpresse gleichzeitig prozessiert werden, mehrere Werkstücksgruppen in Reihe laminiert, und das Einfördern der Werkstücke in die Vakuum-Laminierpresse sowie das Überführen der Werkstücke in den Laminator taktweise vorgenommen.

Wenn der Arbeitstakt des Vorlaminierens in der Vakuum-Laminierpresse kürzer ist, als der Arbeitstakt des Laminators zum Aushärten der Kleberschichten, kann es dann sinnvoll sein, mehr als einen Laminator hinter die Vakuum-Laminierpresse zu schalten. Beispielsweise kann dann der Aushärtetakt bei Verwendung von zwei Laminatoren doppelt so lang sein, wie der Arbeitstakt der Vakuum-Laminierpresse, ohne einen Leerlauf der Vakuum-Laminierpresse in Kauf nehmen zu müssen.

Anstatt eines oder mehrerer weiterer Laminatoren, oder zusätzlich hierzu, kann eine Kühleinrichtung zum Abkühlen des Werkstücks auf eine Temperatur unterhalb der Erweichungstemperatur der Kleberschicht nachgeschaltet sein. Eine solche Kühleinrichtung ist vorzugsweise als Presse ausgebildet, um die Werkstücke mittels Kontaktdruck an einer Kühlplatte abzukühlen.

Nach der vorliegenden Erfindung ist es möglich, das Vorlaminieren in der Vakuum-Laminierpresse unter solch niedrigen Temperaturen ablaufen zu lassen, dass die Kleberschicht zwar erweicht bzw. mit einer Erweichung beginnt, dass sie sich jedoch nicht so weit verflüssigt, dass zu besorgen ist, dass Klebstoffrückstände an das Andrückmittel oder die Unterseite der Vakuumkammer, die normalerweise als Heizplatte ausgebildet ist, gelangen. Das Weiterprozessieren im nachgeschalteten Laminator erfolgt dann zwar bei Endtemperatur, insbesondere einer Aushärtetemperatur der Kleberschicht, jedoch kann dies dort ohne ein flexibles Andrückmittel erfolgen.

Ganz allgemein liegt ein großer Vorteil der erfindungsgemäßen Verfahrensweise und der entsprechenden Vorrichtung darin, dass die Temperaturführung in den einzelnen Stationen, also der Vakuum-Laminierpresse, dem Laminator und gegebenenfalls weiteren Laminatoren unabhängig voneinander erfolgen können, so dass das Zusammenspiel von Erwärmung und Druck viel individueller gesteuert werden kann, als wenn der gesamte Laminierprozess in einer einzigen Vakuum-Laminierpresse durchgeführt wird. Beispielsweise kann in der Vakuum-Laminierpresse die Zieltemperatur viel höher als die Endtemperatur gewählt werden, um ein schnelles Erwärmen der Werkstücke zu gewährleisten. In diesem Fall sollte der Prozess entsprechend frühzeitig unterbrochen werden, bevor im Werkstück die Endtemperatur erreicht ist. Umgekehrt kann die Zieltemperatur in der Vakuum-Laminierpresse auch deutlich geringer als die Endtemperatur für die Kleberschicht gewählt werden, so dass die Erwärmung der Werkstücke langsamer erfolgt - soweit dies erwünscht ist - und gleichzeitig der Energieeinsatz minimiert wird.

In entsprechender Weise kann der Laminierprozess unter dem Aspekt der eingesetzten Energie sowie im Hinblick auf eine optimierte Temperaturführung dadurch verbessert werden, dass mehrere Laminatoren hintereinandergeschaltet werden, deren Zieltemperaturen von Laminator zu Laminator variieren, insbesondere ansteigen.

Zur Regelung der Wärmeeinleitung in die Werkstücke und für eine verbesserte Druckverteilung können in der Vakuum-Laminierpresse und/oder im Laminator und/oder in der Kühleinrichtung den Werkstücken Druckkissen oder Polster unterlegt und/oder die Werkstücke mit solchen abgedeckt werden. Hierbei ist es für deren Wirkung unerheblich, ob solche Druckkissen oder Polster ortsfest in den Maschinen eingebaut oder lose mit den Werkstücken in die Prozessräume verbracht werden. Zur weiteren Beeinflussung der Temperaturführung im Werkstück können hierbei Druckkissen oder Polster verwendet werden, die über definierte Wärmeleit-Eigenschaften verfügen und den Wärmeübergang dementsprechend definiert verzögern.

Einige Ausführungsbeispiele der vorliegenden Erfindung werden im Folgenden anhand der beigefügten Zeichnungen näher beschrieben und erläutert. Es zeigen:
- Figur 1: eine schematische seitliche Teildarstellung einer geöffneten Vakuum-Laminierpresse;
- Figur 2: eine schematische seitliche Teildarstellung wie Figur 1, jedoch einer anderen Ausführung;
- Figur 3: eine schematische seitliche Darstellung einer erfindungsgemäß ausgebildeten Produktlinie aus einer Vakuum-Laminierpresse, einem Laminator und einer Kühleinrichtung;
- Figur 4a, 4b: schematische seitliche Darstellungen von zu laminierenden Werkstücken;
- Figur 5: eine schematische Darstellung einer erfindungsgemäß ausgestalteten Produktionslinie;
- Figur 6: eine schematische Darstellung einer Variation einer erfindungsgemäß ausgestalteten Produktionslinie;
- Figur 7: ein Diagramm verschiedener Parameter der prozessierten Werkstücke über der Zeit in einer Vakuum-Laminierpresse nach dem Stand der Technik;
- Figur 8: ein Diagramm wie Figur 7, jedoch mit einem erfindungsgemäß aufgeteilten Prozess in einer Vakuum-Laminierpresse und zwei nachgeschalteten Laminatoren;
- Figur 9: eine Darstellung wie in Figur 8, jedoch mit anderen Randbedingungen;
- Figur 10: eine Ergänzung der Figuren 8 und 9 durch eine Kühleinrichtungs-Station.

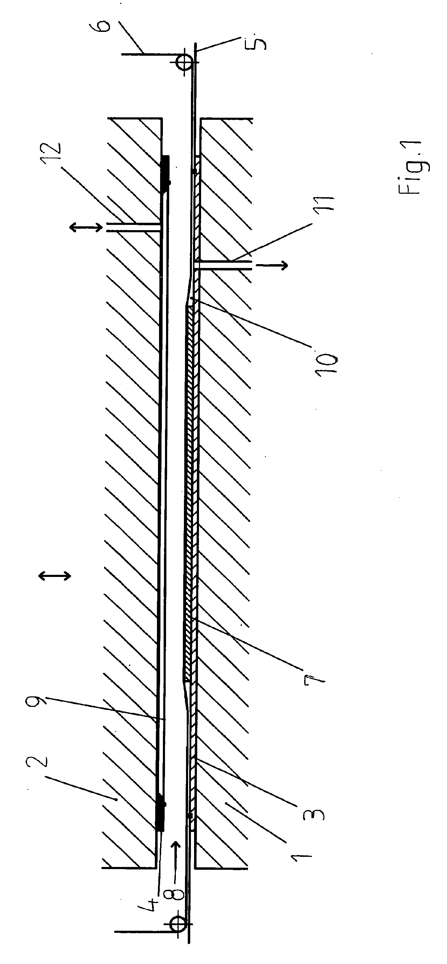

Figur 1 zeigt in einer schematischen seitlichen Teildarstellung eine Vakuum-Laminierpresse mit einem Pressenunterteil 1, einem Pressenoberteil 2 sowie einer Heizplatte 3 und einem Dichtrahmen 4. Zwischen der Heizplatte 3 und dem Dichtrahmen 4 laufen ein Förderband 5 sowie eine Trennfolie 6 durch. Zwischen dem Förderband 5 und der Trennfolie 6 angeordnet, befindet sich ein Werkstück 7 auf der Heizplatte 3, um nach dem Schließen der dargestellten Presse vorlaminiert zu werden. Die Heizplatte 3, das Pressenoberteil 2 sowie der Dichtrahmen 4 bilden bei geschlossener Presse die Begrenzungen einer Vakuumkammer 8, die durch die Trennfolie 6 in eine Druckhälfte 9, die vom Pressenoberteil 2, vom Dichtrahmen 4 und von der Trennfolie 6 begrenzt wird, und eine Produkthälfte 10, die von der Heizplatte 3 und der Trennfolie 6 begrenzt wird, geteilt ist. Die Produkthälfte 10 kann über einen lediglich schematisch dargestellten Kanal 11 abgesaugt werden, während die Produkthälfte 9 mittels eines wiederum lediglich schematisch dargestellten Kanals 12 ebenfalls evakuiert oder aber mit Druckluft beaufschlagt werden kann.

Wenn die in Figur 1 dargestellte Presse geschlossen ist, wird zunächst die Druckhälfte 9 der Vakuumkammer 8 mittels Absaugens durch den Kanal 12 evakuiert, um die Trennfolie 6 vom Werkstück 7 abzuheben. Nahezu gleichzeitig wird auch die Produkthälfte 10 der Vakuumkammer 8 mittels Absaugens durch den Kanal 11 evakuiert, um eine Blasenbildung in den Kleberschichten des Werkstücks 7 zu vermeiden. Hierbei wird ein Differenzdruck zwischen der Druckhälfte 9 und der Produkthälfte 10 aufrechterhalten, der die Trennfolie 6 weiterhin vom Werkstück 7 fernhält. Nachdem ein zur Verhinderung einer Blasenbildung ausreichendes Vakuum in der Produkthälfte 10 hergestellt ist, wird die Druckhälfte 9 so weit belüftet, dass sich die Druckdifferenz umkehrt. Durch den sich daraus ergebenden Druckunterschied zwischen der Druckhälfte 9 und der Produkthälfte 10 der Vakuumkammer 8 schmiegt sich die Trennfolie 6 eng an das Werkstück 7 an und drückt dieses gegen die Heizplatte 3. Gegebenenfalls wird der Druckunterschied durch Einleiten von Druckluft durch den Druckkanal 12 in die Druckhälfte 9 der Vakuumkammer 8 verstärkt. Um den Druckunterschied bedarfsweise gering zu halten, kann jedoch die Druckhälfte 9 der Vakuumkammer 8 auch evakuiert bleiben.

Nachdem die Erwärmung des Werkstücks 7 durch den Kontakt mit der Heizplatte 3 so weit fortgeschritten ist, dass eine Erweichung der Kleberschichten erfolgt ist, jedoch, soweit aushärtbare Kleber verwendet werden, die Aushärtetemperatur der Kleberschichten noch nicht erreicht ist, wird die Vakuumkammer 8 beidseits belüftet, die Presse geöffnet und das Werkstück 7 auf dem Förderband 5 aus der Presse ausgefördert und in einen (hier nicht dargestellten) Laminator überführt.

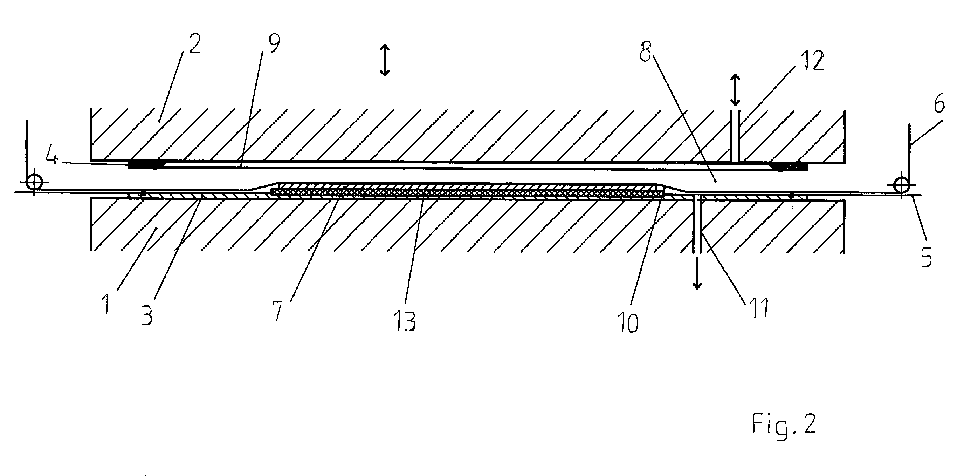

Figur 2 ist eine nahezu identische Darstellung wie Figur 1, jedoch eines modifizierten Ausführungsbeispiels. Gleiche Elemente sind mit gleichen Bezugszeichen versehen, so dass im Wesentlichen auf die Beschreibung der Figur 1 verwiesen werden kann. Der Unterschied zum Ausführungsbeispiel nach Figur 1 liegt darin, dass zwischen die Heizplatte 3 und das Werkstück 7 ein Druckkissen 13 gelegt ist. Dieses gleicht zum einen etwaige Unebenheiten oder Toleranzen in der Parallelität des Werkstücks 7 aus. Zum anderen verzögert es den Wärmeübergang von der Heizplatte 3 in das Werkstück 7 durch definierte Wärmeleiteigenschaften in vorgegebener Art und Weise, so dass ein Evakuieren der Produkthälfte 10 der Vakuumkammer 8 zur Vermeidung einer Blasenbildung im Werkstück 7 erfolgen kann, bevor sich das Werkstück 7 nennenswert erwärmt.

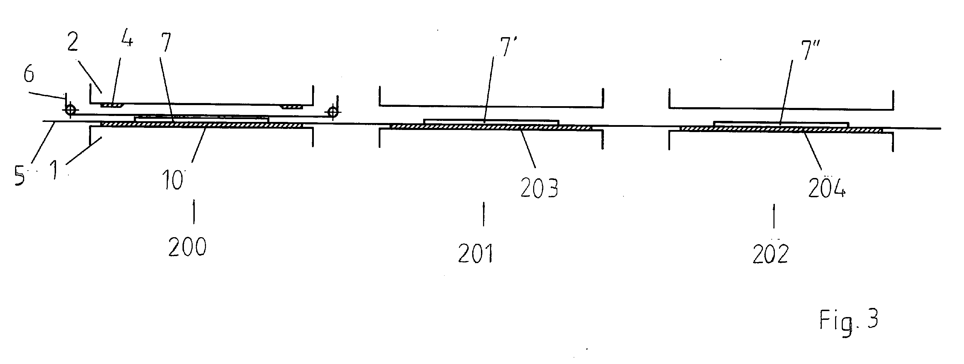

Figur 3 zeigt in einer schematischen seitlichen Darstellung ein Ausführungsbeispiel für eine erfindungsgemäße Vorrichtung zum Laminieren von Photovoltaik-Modulen, die in drei Stationen aufgeteilt ist, nämlich eine Vakuum-Laminierpresse 200, einen Laminator 201 und eine Kühleinrichtung 202. Sowohl der Laminator 201 als auch die Kühleinrichtung 202 sind als Pressen ausgebildet, wobei der Laminator 201 eine Heizplatte 203 und die Kühleinrichtung 202 eine Kühlplatte 204 zum Erwärmen bzw. Abkühlen der Werkstücke 7' und 7" aufweisen. Ein Dichtrahmen 4 ist lediglich bei der Vakuum-Laminierpresse 200 vorhanden; beim Laminator 201 und bei der Kühleinrichtung 202 ist dies nicht erforderlich. Das Förderband 5 führt die hier dargestellte Reihe an Werkstücken 7, 7', 7" taktweise durch die drei Stationen 200, 201, 202, während die Trennfolie 6 lediglich an der Vakuum-Laminierpresse 200 vorgesehen ist und dort das elastische Andrückmittel bildet. Selbstverständlich ist es auch möglich, die Trennfolie 6 durch alle drei Stationen 200, 201, 202 durchzuführen, um zu verhindern, dass sich Klebstoffreste an den jeweiligen Pressenoberteilen festsetzen können, oder in den Stationen 200, 201, 202 jeweils separate Trennfolien oder Folienbahnen zu verwenden.

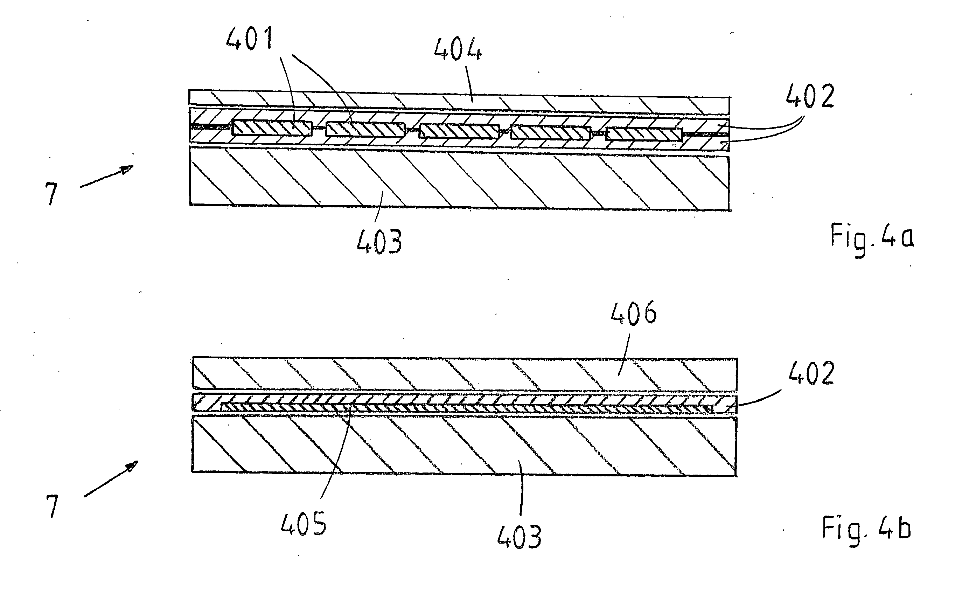

In Figur 4a ist ein Beispiel für ein Werkstück 7 dargestellt, das mit dem erfindungsgemäßen Verfahren laminiert werden soll. Es handelt sich um ein Silizium-Solarzellen-Modul mit einer Anzahl von Silizium-Solarzellen 401, die zwischen zwei Kleberfolien 402 eingebettet sind. Die Vorderseite des Moduls wird durch ein Substratglas 403 gebildet, während auf der Rückseite des Moduls eine Rückseitenfolie 404 aufgelegt ist. Das dargestellte Werkstück 7 wird durch das erfindungsgemäße Verfahren so laminiert, dass das Substratglas 403, die Silizium-Solarzellen 401 und die Rückseitenfolie 404 aufgrund des in den Kleberfolien 402 enthaltenen, vernetzenden oder rein adhäsiv wirkenden Klebers dauerhaft und wetterfest miteinander verbunden werden.

Figur 4b zeigt ein anderes Beispiel für ein zu laminierendes Werkstück 7, das wiederum als Photovoltaik-Modul ausgebildet ist. Dieses enthält jedoch eine Dünnschicht-Solarzelle 405, die zwischen einem Substratglas 403 und einem Rückseitenglas 406 in eine Kleberfolie 402 eingebettet ist. Nach dem Laminiervorgang sind das Substratglas 403 und das Rückseitenglas 406 mit zwischenliegender Dünnschicht-Solarzelle 405 dauerhaft und wetterfest miteinander verbunden.

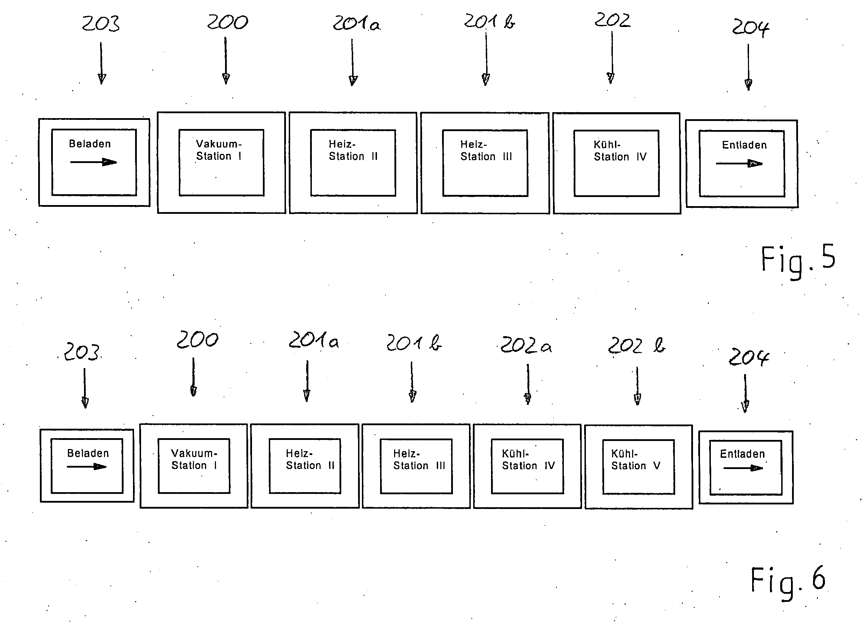

Die Figuren 5 und 6 zeigen schematisch zwei unterschiedliche Ausführungsbeispiele für eine erfindungsgemäße Vorrichtung, wobei im Ausführungsbeispiel nach Figur 5 einer Vakuum-Laminierpresse 200 (Vakuumstation I) zwei Laminatoren 201 a und 201 b (Heizstationen II und II) sowie eine Kühleinrichtung 202 (Kühlstation IV) nachgeschaltet sind. Zum Beladen der Vakuum-Laminierpresse 200 ist eine Beschickungsvorrichtung 203 vorgesehen, während zum Entladen der Kühleinrichtung 202 eine Entladevorrichtung 204 nachgeschaltet ist. Im Ausführungsbeispiel nach Figur 12 sind statt einer einzigen Kühlvorrichtung 202 zwei Kühleinrichtungen 202a und 202b vorgesehen, beispielsweise zur Anpassung der Arbeitstakte an die Vakuum-Laminierpresse 200, deren Arbeitstakt gegebenenfalls zu kurz ist, um ein Herunterkühlen der fertig laminierten Werkstücke in einer einzigen Kühlstation zu ermöglichen.

Bei der folgenden Beschreibung eines Verfahrens nach dem Stand der Technik und eines erfindungsgemäßen Verfahrens wird beispielhaft davon ausgegangen, dass in den Kleberschichten der Werkstücke vernetzende Klebstoffe verwendet werden, die unter Wärmeeinwirkung aushärten. Es sei an dieser Stelle jedoch angemerkt, dass im Rahmen der vorliegenden Erfindung auch andere thermoreaktive Kleber, die rein adhäsiv wirken, verwendet werden können; die Erfindung ist also sowohl für eine Verwendung von Duroplasten als auch von Thermoplasten geeignet und vorteilhaft.

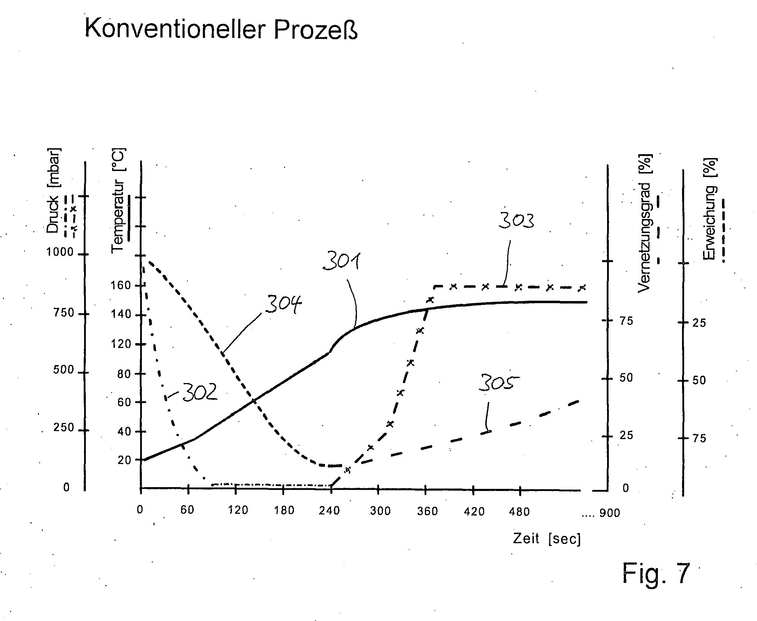

Figur 7 zeigt ein Diagramm verschiedener Randbedingungen eines konventionellen Prozesses in einer Vakuum-Laminierpresse. Gemäß dem Stand der Technik werden hier die Werkstücke bis zur Aushärtung der Kleberschichten in der Vakuum-Laminierpresse prozessiert. Die durchgezogene Linie 301 zeigt die Temperatur im Werkstück an, während die strichpunktierte Linie 302 in der ersten Hälfte des Diagramms den Luftdruck in der Produkthälfte der Vakuumkammer und in der zweiten Hälfte als Linie 303 den auf das Werkstück einwirkenden Kontaktdruck darstellt, im Falle der Linie 302 direkt als Gasdruck in mbar und im Falle der Linie 303 äquivalent zum Gasdruck in mbar eingetragen. Als Folge dieser Randbedingungen (Druck und Temperatur) ergeben sich die gestrichelt eingezeichneten Linien 304 und 305, wobei die Linie 304 die Erweichung der Kleberschichten in % anzeigt, während die Linie 305 den Vernetzungsgrad der Kleberschichten, hier eines vernetzenden Klebstoffs, darstellt.

Wie anhand dieses Diagramms erkennbar ist, erhöht sich die Temperatur der Werkstücke entlang der Linie 301 beginnend von Raumtemperatur (20 °C) bis zur Zieltemperatur (ca. 150 °C), wobei der Anstieg der Linie 301 vom Wärmeübergang zwischen den Heizplatten und den Werkstücken abhängt.

Anhand der schnell abfallenden Linie 302 wird verdeutlicht, dass die Produkthälfte der Vakuumkammer möglichst schnell evakuiert wird, bevor sich die Werkstücke nennenswert erwärmen. Bereits bei einer Werkstücktemperatur unter 50 °C ist der Druck in der Vakuumkammer auf nahezu 5 mbar abgesenkt, so dass eine Blasenbildung in den Kleberschichten vermieden wird. Die Erweichung (Linie 304) der Kleberschichten nimmt entsprechend der Zunahme der Werkstücktemperatur 301 zu. Bei Erreichen einer Temperatur von etwa 120 °C und eines Erweichungsgrades von über 80 %, wird die Druckhälfte der Vakuumkammer belüftet, so dass das Andrückmittel, das die Druckhälfte von der (weiterhin evakuierten) Produkthälfte der Vakuumkammer trennt, einen ansteigenden Anpressdruck auf das Werkstück ausübt. Dies wird mit der Linie 303 verdeutlicht. Im vorliegenden Fall wird die Druckhälfte der Vakuumkammer lediglich belüftet, jedoch nicht mit einem zusätzlichen Druck beaufschlagt, so dass der resultierende, auf das Werkstück wirkende Anpressdruck (Linie 303) leicht unterhalb des Atmosphärendrucks bleibt. Mit dem ansteigenden Druck (303) und der ansteigenden Temperatur (301) nimmt der Vernetzungsgrad (305) der Kleberschichten zu, so dass eine Aushärtung erfolgt. Der durch das Belüften der Druckhälfte der Vakuumkammer entstehende Kontaktdruck des Werkstücks gegen die Heizplatte erhöht naturgemäß den Wärmeübergang in das Werkstück, wodurch die Temperatur (301) schneller ansteigt, bis sie sich abflachend der Zieltemperatur annähert.

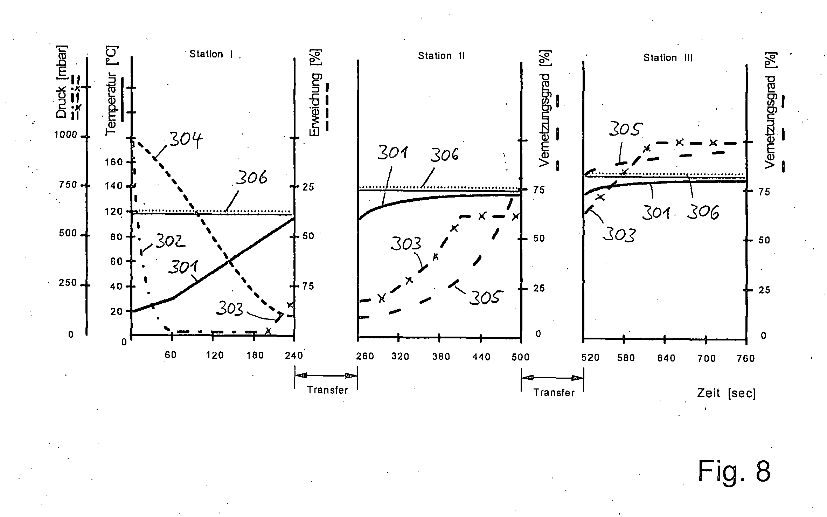

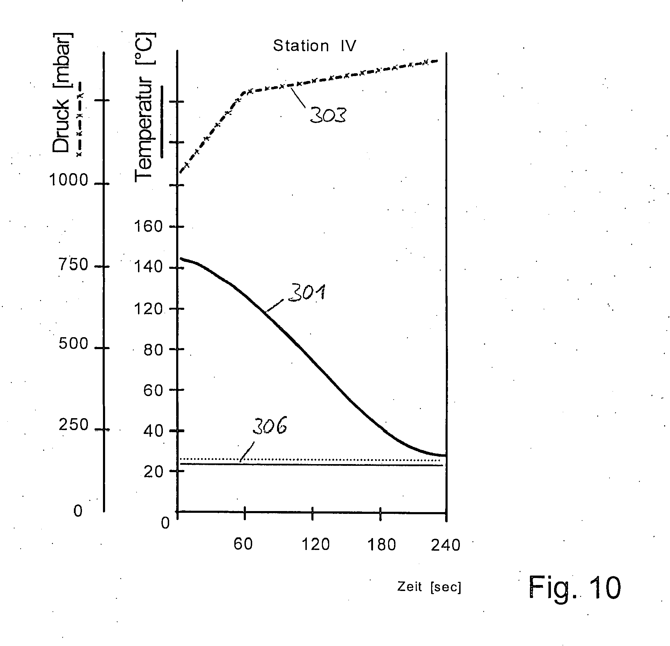

Demgegenüber zeigt Figur 8 ein erstes Beispiel für einen erfindungsgemäß aufgeteilten Prozess, wobei Station I die Vakuum-Laminierpresse, Station II den Laminator und Station III einen zweiten Laminator symbolisiert. Die Kühleinrichtung ist als Station IV in Figur 10 dargestellt.

Wie anhand Figur 8 deutlich wird, wird auch hier in der Station I der Druck in der Produkthälfte der Vakuumkammer (Linie 302) möglichst rasch abgesenkt, um eine Blasenbildung in den Kleberschichten zu verhindern. Da der Prozess erfindungsgemäß auf mehrere Stationen verteilt ist, muss jedoch die Zieltemperatur nicht wie im konventionellen Prozess an oder oberhalb der Aushärtetemperatur der Kleberschichten liegen, sondern kann niedriger gewählt werden. Vorliegend liegt die Zieltemperatur bei 120 °C, was durch eine Doppellinie 306 verdeutlicht ist.

Durch die herabgesetzte Zieltemperatur 306 erwärmt sich das Werkstück langsamer, was in einer flacheren Temperaturkurve 301 resultiert. Dementsprechend erfolgt auch die Erweichung 304 der Kleberschichten langsamer, so dass das Evakuieren des Produktraums (Linie 302) noch vor einer nennenswerten Erweichung der Kleberschichten vollzogen werden kann.

Die Aushärtung der Kleberschichten erfolgt sodann stufenweise in den Stationen II und III, also in zwei hintereinandergeschalteten Laminatoren. Im ersten Laminator (Station II) liegt die Zieltemperatur 306 immer noch gegenüber der Aushärtetemperatur auf abgesenktem Niveau, vorliegend auf ca. 140 °C, so dass sich die Temperatur 301 nur langsam, und erst in der zweiten Stufe in Station III der Zieltemperatur 150 °C annähert. Da die Laminatoren der Stationen II und III als Heißpressen ausgestaltet sind, kann der auf die Werkstücke einwirkende Anpressdruck, wie die Linie 303 zeigt, zur optimalen Vernetzung (Linie 305) geregelt werden. Durch zunächst nur einseitiges Belüften der Druckhälfte der Vakuumkammer in Station I und erst nachfolgend beidseitiges Belüften zum Öffnen der Vakuum-Laminierpresse, wird im Übrigen bereits in Station I ein gewisser Anpressdruck - Linie 303 - auf das Werkstück ausgeübt.

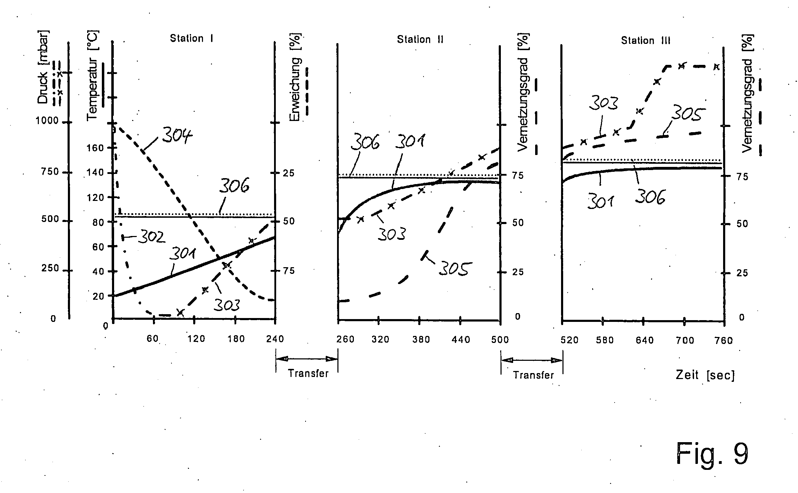

In Figur 9 wird ein weiteres Beispiel der Prozessführung im erfindungsgemäßen Verfahren gezeigt, das dem in Figur 8 dargestellten Beispiel entspricht, jedoch hinsichtlich der Prozessparameter anders ausgestaltet ist. Hier wird insbesondere in Station III ein höherer Anpressdruck auf die Werkstücke aufgebracht, während die Zieltemperaturen wie im Beispiel nach Figur 8 gewählt sind. Auch das Beaufschlagen der Werkstücke mit einem Anpressdruck in Station I zur besseren Vermeidung einer Blasenbildung beim Vorlaminieren wird hier früher und in größerem Ausmaß vorgenommen.

Figur 10 vervollständig sowohl Figur 8 als auch Figur 9 mit einer Station IV, die eine Kühleinrichtung symbolisiert. Dementsprechend liegt hier die Zieltemperatur 306 bei Raumtemperatur und der Verlauf der Werkstücktemperatur 301 ist abfallend, von der Aushärtetemperatur von nahezu 150 °C auf Raumtemperatur. Der Wärmeübergang von den Kühlplatten (306) zu den Werkstücken (301) wird durch einen Anpressdruck 303 verbessert, weshalb die Kühleinrichtung (Station IV) als Presse mit Kühlplatten ausgestaltet ist.

Abschließend sei festgehalten, dass sowohl die Vakuum-Laminierpresse als auch der Laminator und gegebenenfalls weitere Laminatoren oder Kühleinrichtungen jeweils ein- oder mehretagig ausgebildet sein können.

## Patentansprüche

1. Verfahren zum Laminieren von im Wesentlichen plattenförmigen Werkstücken mit mindestens einer durch Wärme aktivierbaren Kleberschicht unter Druck- und Wärmeeinwirkung, wobei zunächst mindestens ein Werkstück in eine Vakuumkammer einer Vakuum-Laminierpresse eingefördert wird, die von einem gasdichte flexiblen Andrückmittel in eine Produkthälfte und eine Druckhälfte unterteilt ist, wobei dann das Werkstück in der Produkthälfte der Vakuumkammer unter Wärmeeinwirkung einem Laminierprozess unterzogen wird, bei dem die Produkthälfte evakuiert wird und das Andrückmittel durch den hierdurch entstehenden Differenzdruck und/oder durch ein zusätzliches Druckbeaufschlagen der Druckhälfte der Vakuumkammer das Werkstück direkt oder indirekt gegen die Unterseite der Vakuumkammer presst, und wobei schließlich der Laminierprozess durch Öffnen der Vakuum-Laminierpresse unterbrochen, das Werkstück in einen Laminator überführt und dort mit einer Temperatur an oder oberhalb der Aktivierungstemperatur und/oder der Aushärtetemperatur der Kleberschicht beaufschlagt wird,
**dadurch gekennzeichnet,**
**dass** als flexibles Andrückmittel eine separat oder zusammen mit dem Werkstück in die Vakuum-Laminierpresse eingebrachte Folie oder eine durch die Vakuumkammer geführte Folienbahn verwendet wird.

2. Verfahren nach Anspruch 1,
**dadurch gekennzeichnet,**
**dass** als flexibles Andrückmittel eine durch die Vakuumkammer geführte Folienbahn aus sich leicht vom Werkstück lösenden Material verwendet wird.

3. Verfahren nach Anspruch 2,
**dadurch gekennzeichnet,**
**dass** als Material der Folienbahn ein haftungsresistentes Material, insbesondere eine PTFE-Folie oder eine mit PTFE- beschichtete Trägerfolie verwendet wird.

4. Verfahren nach mindestens einem der Ansprüche 1 bis 3,
**dadurch gekennzeichnet,**
**dass** das Werkstück nach dem Laminator in einen weiteren Laminator und/oder in eine Kühleinrichtung zum Abkühlen des Werkstücks auf eine Temperatur unterhalb der Erweichungstemperatur der Kleberschicht überführt wird.

5. Verfahren nach mindestens einem der Ansprüche 1 bis 4,
**dadurch gekennzeichnet,**
**dass** mehrere Werkstücke oder mehrere Werkstückgruppen in Reihe laminiert werden und das Einfördern der Werkstücke in die Vakuum-Laminierpresse sowie das Überführen der Werkstücke in den Laminator taktweise erfolgt.

6. Verfahren nach mindestens einem der Ansprüche 1 bis 4,
**dadurch gekennzeichnet,**
**dass** zur Beeinflussung der zeitlichen Wärmeeinwirkung auf die Kleberschicht des Werkstücks in der Vakuum-Laminierpresse und/oder im Laminator und/oder in der Kühleinrichtung zwischen das Werkstück und den jeweiligen Wärmeaustauschflächen Druckkissen oder Polster mit jeweils definierten Wärmeleit-Eigenschaften eingelegt werden.

7. Verfahren nach mindestens einem der Ansprüche 1 bis 6,
**dadurch gekennzeichnet,**
**dass** die Wärmeeinwirkung in der Vakuum-Laminierpresse auf das Werkstück so geregelt wird, dass die Kleberschicht erweicht wird und der Laminierprozess beginnt, dass die Temperatur in der Kleberschicht jedoch unter der Endtemperatur bleibt.

8. Verfahren nach Anspruch 7,
**dadurch gekennzeichnet,**
**dass** zur Regelung der Wärmeeinwirkung in der Vakuum-Laminierpresse eine Zieltemperatur entsprechend niedrig gewählt oder der Prozess entsprechend frühzeitig abgestoppt wird.

9. Verfahren nach einem der Ansprüche 7 oder 8,
**dadurch gekennzeichnet,**
**dass** mehrere hintereinandergeschaltete Laminatoren verwendet werden, deren Zieltemperaturen von Laminator zu Laminator variieren, insbesondere ansteigen.

10. Vorrichtung zum Laminieren von im Wesentlichen plattenförmigen, mit mindestens einer durch Wärme aktivierbaren Kleberschicht (402) versehenen Werkstücken (7) unter Druck- und Wärmeeinwirkung, umfassend eine Vakuum-Laminierpresse (200) mit einer Vakuumkammer (8), die von einem gasdichten flexiblen Andrückmittel (6) in eine Produkthälfte (10) und eine Druckhälfte (9) unterteilt ist, wobei die Produkthälfte (10) zur Aufnahme von mindestens einem Werkstück (7) vorgesehen und evakuierbar ist, während die Druckhälfte (9) evakuierbar und druckbeaufschlagbar ist, und wobei das flexible Andrückmittel (6) so ausgestaltet ist, dass es aufgrund eines durch Evakuieren der Produkthälfte (10) und/oder durch ein Druckbeaufschlagen der Druckhälfte (9) vorhandenen Druckunterschieds in der Vakuumkammer (8) das Werkstück (7) direkt oder indirekt gegen eine Unterseite (3) der Vakuumkammer (8) presst, mit mindestens einem, der Vakuum-Laminierpresse (200) nachgeschalteten Laminator (201), in dem das Werkstück (7) mit einer Temperatur an oder oberhalb der Aktivierungstemperatur und/oder der Aushärtetemperatur der Kleberschicht (402) beaufschlagt wird, sowie mit Fördereinrichtungen (5) zum Einfördern des Werkstücks (7) in die Vakuum-Laminierpresse (200) und zum Überführen des Werkstücks (7) von der Vakuum-Laminierpresse (200) in den Laminator (201),
**dadurch gekennzeichnet,**
**dass** das flexible Andrückmittel eine separat oder zusammen mit dem Werkstück (7) in die Vakuum-Laminierpresse (200) eingebrachte Folie (6) oder eine durch die Vakuumkammer (8) geführte Folienbahn ist.

11. Vorrichtung nach Anspruch 10,
**dadurch gekennzeichnet,**
**dass** das flexible Andrückmittel eine durch die Vakuumkammer (8) geführte Folienbahn (6) ist, die aus sich leicht vom Werkstück (7) lösenden Material besteht.

12. Vorrichtung nach Anspruch 11,
**dadurch gekennzeichnet,**
**dass** die Folienbahn (6) aus einem haftungsresistenten Material, insbesondere aus einer PTFE-Folie oder einer mit PTFE beschichteten Trägerfolie besteht.

13. Vorrichtung nach mindestens einem der Ansprüche 10 bis 12,
**dadurch gekennzeichnet,**
**dass** dem Laminator (201) ein weiterer Laminator (201 a, 201 b) und/oder eine Kühleinrichtung (202) zum Abkühlen des Werkstücks (7) auf eine Temperatur unterhalb der Erweichungstemperatur der Kleberschicht (402) nachgeschaltet ist.

14. Vorrichtung nach mindestens einem der Ansprüche 10 bis 13,
**dadurch gekennzeichnet,**
**dass** sie taktweise arbeitet.

15. Vorrichtung nach mindestens einem der Ansprüche 10 bis 14,
**dadurch gekennzeichnet,**
**dass** in der Vakuum-Laminierpresse (200) oder im Laminator (201) und/oder in der Kühleinrichtung (202) dem Werkstück (7) Druckkissen (13) oder Polster unterlegt sind und/oder auf das Werkstück (7) Druckkissen (13) oder Polster aufgelegt sind.

16. Vorrichtung nach Anspruch 15,
**dadurch gekennzeichnet,**
**dass** die Druckkissen (13) oder Polster zur Beeinflussung der zeitlichen Wärmeeinwirkung auf die Kleberschicht (402) des Werkstücks (7) jeweils definierte Wärmeleit-Eigenschaften aufweisen.

17. Vorrichtung nach mindestens einem der Ansprüche 10 bis 16,
**dadurch gekennzeichnet,**
**dass** die Prozesstemperatur in der Vakuum-Laminierpresse (200) unabhängig vom Laminator (201) führbar ist, insbesondere **dadurch**, dass die Zieltemperatur höher oder niedriger einstellbar ist.

18. Vorrichtung nach Anspruch 17,
**dadurch gekennzeichnet,**
**dass** die Wärmeeinwirkung auf das Werkstück (7) in der Vakuum-Laminierpresse (200) so regelbar ist, dass die Kleberschicht (402) erweicht wird und der Laminierprozess beginnt, dass die Temperatur in der Kleberschicht (402) jedoch unter deren Endtemperatur bleibt.
